# EUROPÄISCHE PATENTSCHRIFT

(11) **EP 3 390 985 B1**
(45) Veröffentlichungstag und Bekanntmachung des Hinweises auf die Patenterteilung: **14.07.2021**
(21) Anmeldenummer: 16805407.0
(22) Anmeldetag: 01.12.2016
(51) Int. Cl.: G01F 25/00, G01F 23/296, G01F 23/24, G01F 23/26

(54) **ELEKTRONIKEINHEIT MIT DIAGNOSEFUNKTION**
ELECTRONIC UNIT WITH DIAGNOSIS FUCTION
UNITÉ ELECTRONIQUE AVEC FONCTION DE DIAGNOSTIC

(30) Priorität: 18.12.2015 DE 102015122284
(43) Veröffentlichungstag der Anmeldung: 24.10.2018
(73) Patentinhaber: Endress+Hauser SE+Co. KG, 79689 Maulburg (DE)
(72) Erfinder: DÖTSCH, Michael, 79736 Rickenbach (DE); FERRARO, Franco, 79739 Schwörstadt (DE); LEISINGER, Ralf, 79699 Wieslet (DE); MONSE, Benjamin, 79206 Breisach (DE)
(74) Vertreter: Andres, Angelika Maria
(86) Internationale Anmeldenummer: PCT/EP2016/079485
(87) Internationale Veröffentlichungsnummer: WO 2017/102365

(56) Entgegenhaltungen:
- EP-A1- 1 091 199
- EP-A1- 1 480 023
- EP-A2- 1 624 291
- WO-A1-2011/035123
- GB-A- 2 081 452
- US-A- 5 121 632

## Beschreibung

Die Erfindung betrifft eine Vorrichtung zur Bestimmung und/oder Überwachung zumindest eines vorgegebenen Füllstands eines Mediums zumindest mit einer Sensoreinheit und einer Elektronikeinheit mit Diagnosefunktion, sowie ein Verfahren zum Betreiben einer entsprechenden Vorrichtung.

Derartige auch als Grenzstandschalter bezeichnete Messgeräte können beispielsweise als vibronische Sensoren mit zumindest einer mechanisch schwingfähigen Einheit oder als kapazitive und/oder konduktive Sensoren ausgestaltet sein. Die Grundprinzipien und unterschiedlichen Ausgestaltung sind aus einer Vielzahl von Veröffentlichungen bekannt geworden. Entsprechende Feldgeräte werden von der Anmelderin in großer Vielfalt hergestellt und im Falle von vibronischen Füllstandsmessgeräten beispielsweise unter der Bezeichnung LIQUIPHANT und/oder SOLIPHANT, und im Falle von kapazitiven und/oder konduktiven Messgeräten beispielsweise unter der Bezeichnung LIQUIPOINT vertrieben.

Im Falle eines vibronischen Grenzstandschalters für Flüssigkeiten wird unterschieden, ob die schwingfähige Einheit von der Flüssigkeit bedeckt ist oder frei schwingt. Diese beiden Zustände, der Freizustand und der Bedecktzustand, werden dabei anhand unterschiedlicher Resonanzfrequenzen, also einer Frequenzverschiebung, unterschieden. Die Dichte und/oder Viskosität wiederum lassen sich mit einem derartigen Messgerät nur bei einer zumindest teilweisen Bedeckung mit dem Medium ermitteln.

Im Falle eines konduktiven Grenzstandschalters wird dagegen erkannt, ob über ein leitfähiges Medium ein elektrischer Kontakt zwischen einer Sondenelektrode und der Wandung eines leitfähigen Behälters oder einer zweiten Elektrode besteht. Im kapazitiven Messverfahren wird dagegen der Füllstand aus der Kapazität des von einer Sondenelektrode und der Wandung des Behälters oder einer zweiten Elektrode gebildeten Kondensators ermittelt. Je nach Leitfähigkeit des Mediums bildet entweder das Medium selbst oder eine Sondenisolierung das Dielektrikum des Kondensators.

Grenzstandschalter werden häufig über eine Zweidrahtleitung betrieben, d. h. dass sowohl die Spannungsversorgung als auch die Signalübertragung über ein gemeinsames Leitungspaar erfolgt. Die Zweidrahtleitungen sind wiederum häufig für 4-20mA Schnittstellen oder auch gemäß dem NAMUR Standard ausgelegt. Dies hat zur Folge, dass den jeweiligen Feldgeräten nur eine sehr begrenzte Leistungsaufnahme zur Verfügung steht. Soll das Feldgerät neben einer Messwerterfassung noch über weitere Funktionen verfügen, stellt dies höchste Anforderungen an die Konzeption und den Aufbau des Gerätes.

Zustandsüberwachungen für vibronischen Sensoren sind beispielsweise aus EP1624291A2, für kapazitive Sensoren beispielsweise aus US5121632 oder GB2081452A oder allgemein für Grenzstandsensoren aus EP1091199A1 oder EP1480023A1 bekannt geworden.

Ausgehend hiervon liegt der vorliegenden Erfindung die Aufgabe zugrunde, die Funktionalität eines Zweileiter-Messgerätes mit begrenzter Leistungsaufnahme zu erweitern.

Bezüglich der Vorrichtung wird die erfindungsgemäße Aufgabe gelöst durch eine Vorrichtung zur Bestimmung und/oder Überwachung eines vorgegebenen Füllstands eines Mediums in einem Behälter mit einer Sensoreinheit und einer Elektronikeinheit, wobei es sich bei der Vorrichtung (1) um ein Zweileiter-Messgerät handelt,
wobei die Elektronikeinheit dazu ausgestaltet ist, die Sensoreinheit mit einem Anregesignal zu beaufschlagen, und von der Sensoreinheit ein Empfangssignal zu empfangen, wobei die Elektronikeinheit zumindest umfasst
- eine nach dem NAMUR-Standard ausgelegte Schnittstelle,
- eine erste Recheneinheit (8a), welche dazu ausgestaltet ist, in einem Normalbetriebsmodus (14) aus dem Empfangssignal ein Erreichen des vorgegebenen Füllstands zu bestimmen, und in Form eines Ausgabe-Stromsignals über die Schnittstelle auszugeben,
- eine zweite Recheneinheit (8b), welche dazu ausgestaltet ist, in einem Diagnosebetriebsmodus (15) eine Aussage über den Zustand der Sensoreinheit (3) zu treffen,
- zumindest einen Zwischenspeicher (9,9a,9b,...), welcher dazu ausgestaltet ist, die zumindest eine Aussage über den Zustand der Sensoreinheit (3) zu speichern, und welcher mit der ersten Recheneinheit (8a) und mit der zweiten Recheneinheit (8b) elektrisch verbunden ist, und
- zumindest ein Schaltelement (10a, 10b), mittels welchem zwischen dem Normalbetriebsmodus (14) und dem Diagnosebetriebsmodus (15) hin und her geschaltet werden kann,
wobei das Schaltelement (10a, 10b) derart angeordnet und ausgestaltet ist, dass im Normalbetriebsmodus (14) die erste Recheneinheit (8a) betrieben wird, während die zweite Recheneinheit (8b) ausgeschaltet ist, und dass im Diagnosebetriebsmodus (15) die zweite Recheneinheit (8b) betrieben wird, während die erste Recheneinheit (8a) ausgeschaltet ist.

Das Erreichen des vorgegebenen Füllstands wird über die Elektronikeinheit in Form eines Ausgabe-Stromsignals ausgegeben. Bei einer nach dem NAMUR-Standard ausgelegten Schnittstelle sind für das die Füllstandsmessung repräsentierende Ausgabe-Stromsignal zwei Zustände definiert: Ein Ausgabe-Stromsignal Iₐ<1,2mA entspricht dem Zustand "Alarm" oder "aus", während ein Ausgabe-Stromsignal Iₐ>2,1mA dem Zustand "ein" entspricht. In diesem Fall beträgt die Nenn-Versorgungsspannung 8,2V DC, so dass die für das jeweilige Feldgerät zur Verfügung stehende Leistung beispielsweise im Falle eines Ausgabe-Stromsignals von 1mA lediglich P=8mW beträgt.

Das erfindungsgemäße Feldgerät ist neben der Bestimmung und/oder Überwachung des vorgegebenen Füllstands im Normalbetriebsmodus dazu ausgeführt, innerhalb eines Diagnosebetriebsmodus eine Diagnosefunktion auszuführen. Dabei wird das Feldgerät mittels einer gemäß dem NAMUR-Standard ausgelegten Schnittstelle betrieben. Um die dem NAMUR-Standard entsprechenden Anforderungen in Bezug auf die begrenzte Leistungsaufnahme trotz der Implementierung einer Diagnosefunktion erfüllen zu können, weist das erfindungsgemäße Feldgerät zwei Recheneinheiten auf: eine erste Recheneinheit zur Bestimmung und/oder Überwachung des vorgegebenen Füllstands, und eine zweite Recheneinheit zur Implementierung der Diagnosefunktion, bzw. zum Ermitteln zumindest einer Aussage über den Zustand der Sensoreinheit. Die erste und die zweite Recheneinheit werden bevorzugt abwechselnd eingeschaltet, so dass zu einem beliebigen Zeitpunkt stets nur eine der beiden Recheneinheiten betrieben wird.

Bei der Diagnose handelt es sich um eine Aussage über den Zustand der Sensoreinheit. Beispielsweise kann erkannt werden, ob ein Leitungsbruch oder ein Kurzschluss erfolgt ist. Im Falle eines vibronischen Füllstandsmessgeräts kann beispielsweise auch erkannt werden, ob eine Blockade der mechanisch schwingfähigen Einheit vorliegt, oder ob die Antriebs-/Empfangseinheit beschädigt ist. Im Falle eines nach dem kapazitiven und/oder konduktiven Messverfahren arbeitenden Feldgeräts kann ferner ein Bruch in einer elektrischen Isolation, ein Abriss der Sondeneinheit oder auch das Vorhandensein eines Ansatzes detektiert werden.

In einer bevorzugten Ausgestaltung der Vorrichtung sind zumindest zwei Zwischenspeicher vorgesehen, welche elektrisch parallel zueinander geschaltet sind, wobei im ersten Zwischenspeicher eine erste Aussage über den Zustand der Sensoreinheit speicherbar ist und wobei im zweiten Zwischenspeicher eine zweite Aussage über den Zustand der Sensoreinheit speicherbar ist. Durch die Parallelschaltung mehrerer Zwischenspeicher können somit mehrere Diagnosefunktionen ausgeführt werden, indem beispielsweise jedem der Zwischenspeicher eine bestimmte Aussage über den Zustand der Sensoreinheit zugeordnet wird.

Bevorzugt handelt es sich bei dem Zwischenspeicher um eine Kippstufe, z. B. um eine Kippstufe, welche zwei stabile Zustände annehmen kann. Es ist in dieser Hinsicht von Vorteil, wenn der Zwischenspeicher zumindest einen Kondensator, eine Transistorschaltung, eine Diodenschaltung und/oder einen Speicherbaustein, insbesondere einen NVRAM, umfasst. Am Beispiel eines Kondensators liegt dann beispielsweise ein erster Zustand vor, wenn der Kondensator geladen ist, und ein zweiter Zustand, wenn der Kondensator entladen ist. Der erste Zustand kann dann beispielsweise bedeuten, dass ein Kabelbruch vorliegt, und der zweite Zustand, dass kein Kabelbruch detektiert wurde.

Eine Ausgestaltung der erfindungsgemäßen Vorrichtung sieht vor, dass es sich bei dem Schaltelement um einen elektrischen Wechselschalter oder um zumindest zwei elektrische Schalter handelt. Das zumindest eine Schaltelement sorgt also erfindungsgemäß dafür, dass entweder die erste Recheneinheit oder die zweite Recheneinheit betrieben wird. Es ist also zum Hin- und Herschalten zwischen den beiden Recheneinheiten ausgelegt. Beispielsweise ist das zumindest eine Schaltelement derart angeordnet und ausgelegt, dass jeweils nur die aktive Recheneinheit mit elektrischer Energie versorgt wird.

Im Normalbetriebsmodus wird die erste Recheneinheit betrieben, während die zweite Recheneinheit ausgeschaltet ist. Dagegen wird im Diagnosebetriebsmodus die zweite Recheneinheit betrieben, während die erste Recheneinheit ausgeschaltet ist. Die zweite Recheneinheit speichert dann beispielsweise die jeweilige Aussage über den Zustand des Feldgeräts in zumindest einem Zwischenspeicher. Diese Aussage kann mittels der zweiten oder bevorzugt mittels der ersten Recheneinheit ausgegeben werden. Bevorzugt wird innerhalb des Normalbetriebsmodus nur dann der vorgegebene Füllstand bestimmt und/oder überwacht, wenn innerhalb des Diagnosebetriebsmodus keinerlei Fehlfunktionen oder Defekte des Feldgeräts festgestellt worden sind.

Die zumindest zwei Recheneinheiten werden beispielsweise in bestimmbaren Intervallen abwechselnd betrieben. Alternativ kann der Diagnosebetriebsmodus auch nur auf Bedarf aktiviert werden, z.B. durch manuelle Betätigung des zumindest einen Schaltelements. Außerdem ist es denkbar, dass bei einem Neustart des Feldgeräts automatisch zuerst der Diagnosebetriebsmodus durchlaufen wird, bevor der Normalbetriebsmodus aktiviert wird.

Erfindungsgemäß ist die zweite Recheneinheit elektrisch mit zumindest einem Schaltelement verbunden. So kann die zweite Recheneinheit nach Beendigung der Diagnose im Diagnosebetriebsmodus selbst in den Normalbetriebsmodus zurückschalten, in welchem die erste Recheneinheit betrieben wird. Dies erfolgt beispielsweise dadurch, dass die zweite Recheneinheit das Schaltelement betätigt und sich selbst ausschaltet. Durch die Betätigung des Schaltelements wird dann die erste Recheneinheit mit Energie versorgt und kann den Normalbetriebsmodus starten und gegebenenfalls vor Start des Normalbetriebsmodus den zumindest einen Zwischenspeicher auslesen.

In einer weiteren bevorzugten Ausgestaltung der Vorrichtung ist die erste Recheneinheit dazu ausgestaltet, eine Meldung über die zumindest eine Aussage über den Zustand der Sensoreinheit zu generieren und auszugeben. Die Meldung wird während oder vor Aufnahme des Normalbetriebsmodus generiert und ausgegeben. Zu diesem Zeitpunkt ist bevorzugt die zweite Recheneinheit bereits abgeschaltet. Die erste Recheneinheit erhält die jeweilige Aussage über den Zustand der Sensoreinheit dann aus zumindest einem Zwischenspeicher.

Die erfindungsgemäße Aufgabe wird ferner gelöst durch ein Verfahren zum Betreiben einer Vorrichtung zur Bestimmung und/oder Überwachung eines vorgegebenen Füllstands eines Mediums in einem Behälter, wobei es sich bei der Vorrichtung (1) um ein Zweileiter-Messgerät handelt,
- wobei eine Sensoreinheit (3) mittels eines Anregesignals beaufschlagt wird, und ein Empfangssignal von der Sensoreinheit (3) empfangen wird,
- wobei in einem Normalbetriebsmodus (14) ein Erreichen des vorgegebenen Füllstands aus dem Empfangssignal bestimmt und in Form eines Ausgabe-Stromsignals über eine nach dem NAMUR-Standard ausgelegte Schnittstelle ausgegeben wird,
- wobei in einem Diagnosebetriebsmodus (15) zumindest eine Aussage über den Zustand der Sensoreinheit (3) getroffen wird,
- wobei die zumindest eine Aussage über den Zustand der Sensoreinheit (3) gespeichert wird,
- wobei zwischen dem Normalbetriebsmodus (14) und dem Diagnosebetriebsmodus (15) hin und her geschaltet wird, und
- wobei im Normalbetriebsmodus (14) die erste Recheneinheit (8a) betrieben wird, während die zweite Recheneinheit (8b) ausgeschaltet ist, und wobei im Diagnosebetriebsmodus (15) die zweite Recheneinheit (8b) betrieben wird, während die erste Recheneinheit (8a) ausgeschaltet ist.

In einer bevorzugten Ausgestaltung des erfindungsgemäßen Verfahrens wird der Diagnosebetriebsmodus durch Betätigung des zumindest einen Schaltelements gestartet. Alternativ oder zusätzlich kann der Diagnosebetriebsmodus bei jedem Neustart des Feldgeräts zuerst ausgeführt werden.

Weiterhin wird in einer Ausgestaltung der Diagnosebetriebsmodus durch Betätigen des zumindest einen Schaltelements beendet, wobei gleichzeitig der Normalbetriebsmodus gestartet wird. Alternativ ist es aber auch möglich, dass der Diagnosebetriebsmodus durch die zweite Recheneinheit beendet wird, wobei gleichzeitig der Normalbetriebsmodus gestartet wird.

In einer weiteren bevorzugten Ausgestaltung des Verfahrens wird im Falle eines Defekts oder einer Fehlfunktion der Sensoreinheit eine Meldung generiert und ausgegeben. Zur Bewertung der Funktionsfähigkeit der Sensoreinheit wird beispielsweise der Zwischenspeicher durch die erste Recheneinheit ausgelesen. Alternativ kann die zweite Recheneinheit die Funktionsfähigkeit der Sensoreinheit auch bereits während des Diagnosebetriebsmodus bewerten. Entsprechend kann die Meldung selbst von der zweiten Recheneinheit während des Diagnosebetriebsmodus ausgegeben oder von der ersten Recheneinheit vor oder während des Normalbetriebsmodus ausgegeben werden. Bevorzugt wird sowohl die Bewertung als auch die Generierung der Meldung durch die erste Recheneinheit durchgeführt und mit der Bestimmung und/oder Überwachung des vorgegebenen Füllstands nur fortgefahren, wenn die Auswertung ergibt, dass die Sensoreinheit als funktionsfähig bewertet wurde.

Die in Zusammenhang mit der Vorrichtung erläuterten Ausgestaltungen lassen sich mutatis mutandis auch auf die vorgeschlagenen Verfahren anwenden und umgekehrt.

Die Erfindung sowie ihre vorteilhaften Ausgestaltungen werden nachfolgend anhand der Figuren Fig. 1 - Fig. 3 näher beschrieben. Es zeigt:
Fig. 1: eine schematische Skizze eines vibronischen Sensors gemäß Stand der Technik,
Fig. 2: eine schematische Skizze einer erfindungsgemäßen Elektronikeinheit in einer ersten (a) und zweiten (b) Ausgestaltung, und
Fig. 3 ein Ablaufdiagramm zur Illustration des erfindungsgemäßen Verfahrens.

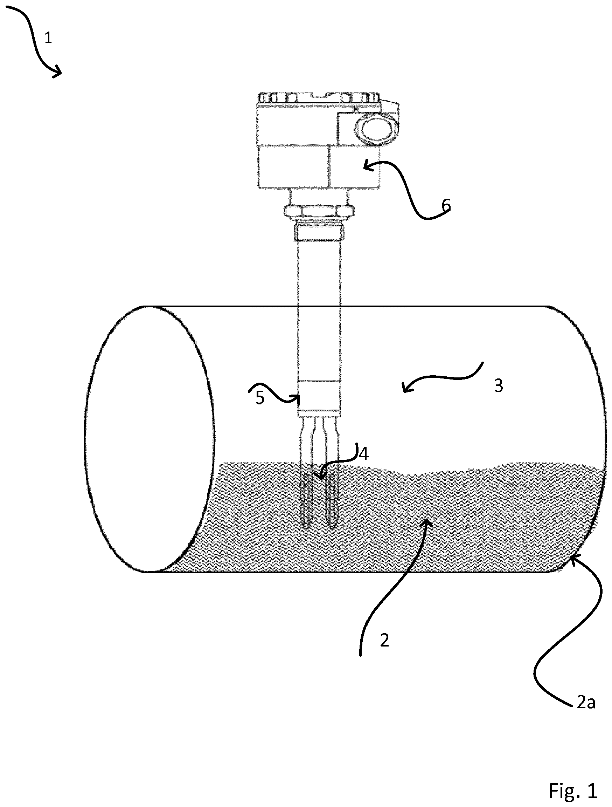

Die nachfolgende Beschreibung bezieht sich ohne Beschränkung der Allgemeinheit auf ein Feldgerät 1 in Form eines vibronischen Sensors zumindest zur Bestimmung und/oder Überwachung eines vorgegebenen Füllstands eines Mediums 2 in einem Behälter 2a. Wie aus Fig. 1 ersichtlich, umfasst die Sensoreinheit 3 eine mechanisch schwingfähige Einheit 4 in Form einer Schwinggabel, welche teilweise in das Medium 2 eintaucht. Andere bekannte und unter die Erfindung fallende Ausgestaltungen einer mechanisch schwingfähigen Einheit 4 sind beispielsweise durch einen Einstab oder eine Membran gegeben. Die mechanisch schwingfähige Einheit 4 wird mittels der Antriebs-/Empfangseinheit 5, welche mit dem Anregesignal beaufschlagt wird, zu mechanischen Schwingungen angeregt, und kann beispielsweise ein Vier-Quadranten-Antrieb oder ein Bimorphantrieb sein. Weiterhin ist eine Elektronikeinheit 6 dargestellt, mittels welcher die Signalauswertung und/oder -speisung erfolgt.

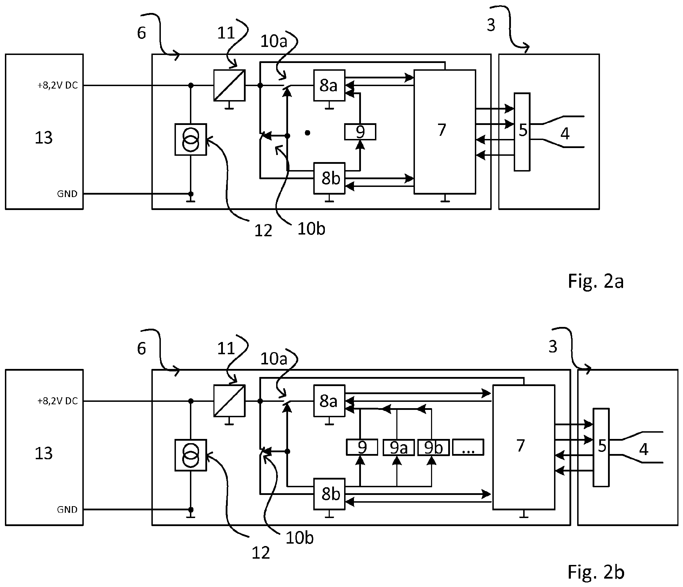

Fig. 2a zeigt beispielhaft eine erste Ausgestaltung einer erfindungsgemäßen Elektronikeinheit 6. Die Sensoreinheit 3 ist mit der Elektronikeinheit 6 elektrisch verbunden. Komponenten der Elektronikeinheit 6, welche direkt der Betreibung und Signalspeisung des Sensorelements sowie der unmittelbaren Weiterverarbeitung des von der Sensoreinheit empfangenen Messsignals dienen, und welche von der Gattung des jeweiligen Feldgeräts abhängen, sind mit dem Bezugszeichen 7 zusammengefasst. Im Falle eines vibronischen Füllstandsmessgeräts sind dies beispielsweise Komponenten des elektrischen Schwingkreises, mittels welchem die mechanisch schwingfähige Einheit 4 zu mechanischen Schwingungen angeregt wird. Die erfindungsgemäße Elektronikeinheit 6 umfasst eine erste Recheneinheit 8a, welche dazu ausgestaltet ist, in einem Normalbetriebsmodus zumindest den vorgegebenen Füllstand zu bestimmen und/oder zu überwachen. Darüber hinaus ist eine zweite Recheneinheit 8b implementiert, mittels welcher in einem Diagnosebetriebsmodus zumindest eine Aussage über den Zustand der Sensoreinheit 3 gemacht werden kann.

Die erste 8a und zweite 8b Recheneinheit sind elektrisch über einen Zwischenspeicher 9 miteinander verbunden, bei welchem es sich bevorzugt um eine Kippstufe handelt, welche zwei Zustände annehmen kann. Im Falle, dass der Zwischenspeicher ein Kondensator ist, und dass eine Aussage über eine Blockade der schwingfähigen Einheit getätigt wird kann beispielsweise ein geladener Kondensator den Zustand "Schwinggabel ist blockiert" und ein entladener Kondensator den Zustand "Schwinggabel ist frei" repräsentieren. Beide Recheneinheiten 8a, 8b sind ferner zur Kommunikation mit der Sensoreinheit 3 ausgestaltet, wobei im Normalbetriebsmodus beispielsweise die erste Recheneinheit 8a die Sensoreinheit 3 mit einem Anregesignal beaufschlagt und ein Empfangssignal von der Sensoreinheit 3 empfängt, und wobei im Diagnosebetriebsmodus die zweite Recheneinheit 8b die Sensoreinheit mit einem Anregesignal beaufschlagt und ein Empfangssignal von der Sensoreinheit 3 empfängt. Die während des Normalbetriebsmodus und Diagnosebetriebsmodus generierten Anregesignale und die jeweils von der Sensoreinheit 3 erhaltenen Empfangssignale können dabei jeweils gleich, oder auch unterschiedlich sein.

Das gezeigte Ausführungsbeispiel zeigt außerdem zwei Schaltelemente 10a, 10b, mittels welchen zwischen den beiden Recheneinheiten 8a, 8b hin und her geschaltet werden kann. Alternativ kann auch ein Wechselschalter integriert werden. Je nach Ausgestaltung der erfindungsgemäßen Vorrichtung ist das zumindest eine Schaltelement 10a, 10b so ausgelegt, dass es von einem Benutzer von außerhalb der Elektronikeinheit 6 aus betätigbar ist, und/oder so, dass zumindest die zweite Recheneinheit 8b das zumindest eine Schaltelement 10a, 10b betätigen kann. Je nach Ausgestaltung der Schaltelemente ergibt sich dann auch, ob der Diagnosemodus zyklisch automatisiert, manuell auf Bedarf, und/oder automatisch bei jedem Neustart des Feldgeräts 1 ausgelöst wird.

Im hier gezeigten Ausführungsbeispiel ermittelt die zweite Recheneinheit 8b im Diagnosebetriebsmodus eine Aussage über den Zustand der Sensoreinheit 3 und speichert diese Aussage in den Zwischenspeicher 9. Anschließend wird durch eine Betätigung der beiden Schaltelemente 10a, 10b der Diagnosebetriebsmodus beendet. Die zweite Recheneinheit 8b schaltet ab oder wird abgeschaltet und die erste Recheneinheit 8a schaltet ein oder wird eingeschaltet. Bevor die erste Recheneinheit 8a gemäß des Normalbetriebsmodus mit der Bestimmung und/oder Überwachung zumindest des vorgegebenen Füllstands beginnt, liest die erste Recheneinheit 8a den Zwischenspeicher 9 aus und generiert eine Meldung über den Zustand der Sensoreinheit 3.

Sowohl die Aussage über den Zustand der Sensoreinheit 3 als auch das Erreichen des vorgegebenen Füllstands werden von der ersten Recheneinheit 8a über den Stromsteller 12 in Form eines entsprechenden Ausgabe-Stromsignals bereitgestellt und an einen NAMUR Trennschalt-Verstärker 13 übergeben. Der Umrichter 11 wiederum dient dazu, die erste 8a bzw. die zweite Recheneinheit 8b intern mit einer vorgebbaren Ausgangsspannung zu versorgen.

In Fig. 2b ist ein weiteres Ausführungsbeispiel für eine erfindungsgemäße Elektronikeinheit 6 gezeigt. Der Unterschied zu dem Beispiel aus Fig. 2a besteht lediglich darin, dass mehrere Zwischenspeicher 9,9a,9b, ... zwischen der ersten 8a und zweiten 8b Recheneinheit integriert sind. Auf bereits erläuterte Bezugszeichen wird deswegen in Zusammenhang mit Fig. 2b nicht erneut eingegangen.

Vorteilhaft kann für das Ausführungsbeispiel gemäß Fig. 2b jedem der Zwischenspeicher 9,9a,9b,... eine andere Aussage über den Zustand des Sensorelements 3 zugeordnet werden, so dass mehrere Diagnosen vorgenommen werden können. Die zweite Recheneinheit 8b führt dann beispielsweise während des Diagnosebetriebsmodus nacheinander mehrere Diagnosefunktionen aus und speichert jeweils die entsprechende Aussage über den Zustand der Sensoreinheit 3 in dem für diese Aussage vorgesehen Zwischenspeicher 9,9a,9b,....

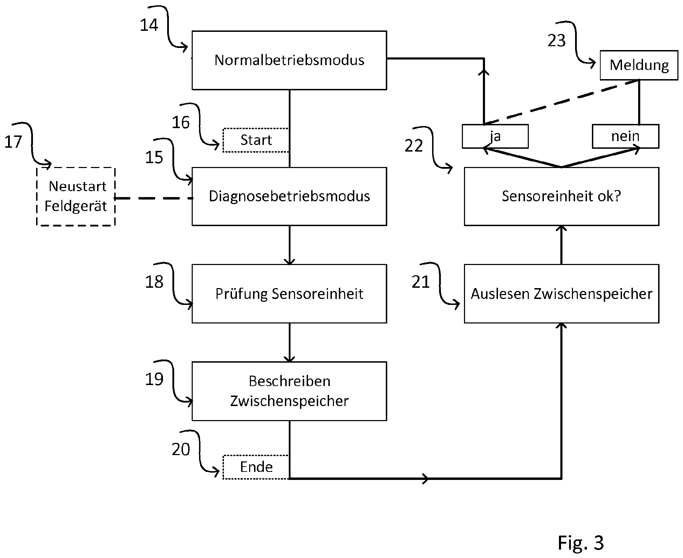

Das erfindungsgemäße Verfahren ist schließlich mittels eines Ablaufdiagramms in Fig. 3 skizziert. Zu Beginn befindet sich das Feldgerät 1 im Normalbetriebsmodus 14. Die erste Recheneinheit 8a bestimmt und/oder überwacht den vorgegebenen Füllstand und übermittelt das Erreichen des vorgegebenen Füllstands mittels eines entsprechenden Ausgabe-Stromsignals. Der Diagnosebetriebsmodus 15 kann in dem gezeigten Diagramm auf drei verschiedene Arten ausgelöst werden:
1) durch manuelle Betätigung 16 der Schaltelemente 10a, 10b,
2) automatisiert in periodischen Intervallen (kein separates Startereignis erforderlich, das Umschalten in den Diagnosebetriebsmodus 15 kann dann beispielsweise durch die erste Recheneinheit 8a veranlasst werden, indem diese z. B. dazu ausgestaltet ist, die Schaltelemente 10a, 10b zu betätigen und/oder sich durch die Betätigung der Schaltelemente 10a, 10b abzuschalten), und/oder
3) Bei einem Neustart 17 des Feldgeräts 1 (durch den Neustart wird dann bewirkt, dass die Schaltelemente 10a, 10b entsprechend des Diagnosebetriebsmodus 15 eingestellt sind, dass also die zweite Recheneinheit 8b mit elektrischer Leistung versorgt und eingeschaltet wird).

Während des Diagnosebetriebsmodus wird der Zustand der Sensoreinheit 2 überprüft 18 und das Ergebnis im Zwischenspeicher 9 gespeichert 19. Im Falle, dass mehrere Zwischenspeicher vorhanden sind, können mehrere Aussagen über das Sensorelement 3 getroffen und zwischengespeichert werden. Der Diagnosebetriebsmodus 15 wird bevorzugt vermittels der zweiten Recheneinheit 8b beendet. Die zweite Recheneinheit 8b betätigt die Schaltelemente 10a, 10b und schaltet sich ab, bzw. wird durch die Betätigung der Schaltelemente 10a, 10b abgeschaltet.

Durch die Betätigung der Schaltelemente 10a, 10b wird wieder die erste Recheneinheit 8a mit elektrischer Leistung versorgt und nimmt ihren Betrieb wieder auf. Zuerst wird/werden der Zwischenspeicher oder die Zwischenspeicher 9, 9a, 9b 9 ausgelesen 21. Sofern in den Zwischenspeichern 9, 9a, 9b,... hinterlegt ist, dass das Sensorelement 3 bezüglich der dem jeweiligen Zwischenspeicher 9,9a,9b,... zugeordneten Aussage über das Sensorelement 3 positiv ausfällt 22 , wird der Normalbetriebsmodus 14 begonnen oder wieder aufgenommen und der vorgegebene Füllstand bestimmt und/oder überwacht. Optional kann zusätzlich eine Meldung 23 generiert werden, die die Funktionsfähigkeit des Sensorelements 3 anzeigt [dargestellt durch die gestrichelte Linie]. Ergibt das Auslesen 21 zumindest eines der Zwischenspeicher 9,9a,9b,... jedoch, dass das Sensorelement 3 bezüglich der dem jeweiligen Zwischenspeicher 9,9a,9b,... zugeordneten Aussage über das Sensorelement 3 negativ ausfällt 22, so wird eine Meldung 23 hierüber generiert. Bevorzugt wird dann der Normalbetriebsmodus 14 nicht wieder aufgenommen.

Die Verfahrensschritte des Auslesens 21 und Bewertens 22 der in den Zwischenspeichern 9,9a,9b,... gespeicherten Aussagen über den Zustand des Sensorelements 3 können im Prinzip für die gezeigten Ausgestaltungen dem Normalbetriebsmodus 14 zugeordnet werden. Bevor mit der Füllstandsbestimmung und/oder-Überwachung begonnen wird, werden bevorzugt immer zuerst die Zwischenspeicher 9,9a,9b,... ausgelesen. Es versteht sich jedoch von selbst, dass auch andere Ausgestaltungen möglich sind, für welche diese Zuordnung nicht zutreffend ist.

### Bezugszeichenliste

- 1: Feldgerät
- 2: Medium
- 2a: Behälter
- 3: Sensoreinheit
- 4: Schwingfähige Einheit in Form einer Schwinggabel
- 5: Antriebs-/Empfangseinheit
- 6: Elektronikeinheit
- 7: Komponenten der Elektronikeinheit betreffend die Anregung der Sensoreinheit und die direkte Signalverarbeitung
- 8: a erste und b zweite Recheneinheit
- 9: a,b,... Zwischenspeicher
- 10: a, b, Schaltelemente
- 11: Umrichter
- 12: Stromsteller
- 13: Trennschalt-Verstärker
- 14: Normalbetriebsmodus
- 15: Diagnosebetriebsmodus
- 16: Start des Diagnosebetriebsmodus
- 17: Neustart Feldgerät
- 18: Prüfung Sensoreinheit
- 19: Beschreiben Zwischenspeicher
- 20: Ende des Diagnosebetriebsmodus
- 21: Auslesung Zwischenspeicher
- 22: Bewertung Zwischenspeicher
- 23: Auslesung Zwischenspeicher

## Patentansprüche

1. Vorrichtung (1) zur Bestimmung und/oder Überwachung eines vorgegebenen Füllstands eines Mediums (2) in einem Behälter (2a) mit einer Sensoreinheit (3) und einer Elektronikeinheit (6),
wobei es sich bei der Vorrichtung (1) um ein Zweileiter-Messgerät handelt,
wobei die Elektronikeinheit (6) dazu ausgestaltet ist, die Sensoreinheit (3) mit einem Anregesignal zu beaufschlagen und von der Sensoreinheit (3) ein Empfangssignal zu empfangen,
wobei die Elektronikeinheit (6) zumindest umfasst
- eine nach dem NAMUR-Standard ausgelegte Schnittstelle,
- eine erste Recheneinheit (8a), welche dazu ausgestaltet ist, in einem Normalbetriebsmodus (14) aus dem Empfangssignal ein Erreichen des vorgegebenen Füllstands zu bestimmen, und in Form eines Ausgabe-Stromsignals über die Schnittstelle auszugeben,
- eine zweite Recheneinheit (8b), welche dazu ausgestaltet ist, in einem Diagnosebetriebsmodus (15) eine Aussage über den Zustand der Sensoreinheit (3) zu treffen,
- zumindest einen Zwischenspeicher (9,9a,9b,...), welcher dazu ausgestaltet ist, die zumindest eine Aussage über den Zustand der Sensoreinheit (3) zu speichern, und welcher mit der ersten Recheneinheit (8a) und mit der zweiten Recheneinheit (8b) elektrisch verbunden ist, und
- zumindest ein Schaltelement (10a, 10b), mittels welchem zwischen dem Normalbetriebsmodus (14) und dem Diagnosebetriebsmodus (15) hin und her geschaltet werden kann,
wobei das Schaltelement (10a, 10b) derart angeordnet und ausgestaltet ist, dass im Normalbetriebsmodus (14) die erste Recheneinheit (8a) betrieben wird, während die zweite Recheneinheit (8b) ausgeschaltet ist, und dass im Diagnosebetriebsmodus (15) die zweite Recheneinheit (8b) betrieben wird, während die erste Recheneinheit (8a) ausgeschaltet ist.

2. Vorrichtung (1) nach Anspruch 1,
wobei zumindest zwei Zwischenspeicher (9,9a,9b,...) vorgesehen sind, welche elektrisch parallel zueinander geschaltet sind, und wobei im ersten Zwischenspeicher (9) eine erste Aussage über den Zustand der Sensoreinheit (3) speicherbar ist und wobei im zweiten Zwischenspeicher (9a) eine zweite Aussage über den Zustand der Sensoreinheit (3) speicherbar ist.

3. Vorrichtung nach Anspruch 1 oder 2,
wobei es sich bei dem Zwischenspeicher (9,9a,9b,...) um eine Kippstufe handelt.

4. Vorrichtung nach zumindest einem der vorhergehenden Ansprüche,
wobei der Zwischenspeicher (9,9a,9b,...) zumindest einen Kondensator, eine Transistorschaltung, eine Diodenschaltung und/oder einen Speicherbaustein, insbesondere einen NVRAM, umfasst.

5. Vorrichtung nach zumindest einem der vorhergehenden Ansprüche,
wobei es sich bei dem Schaltelement (10a, 10b) um einen elektrischen Wechselschalter oder um zumindest zwei elektrische Schalter handelt.

6. Vorrichtung nach zumindest einem der vorhergehenden Ansprüche,
wobei die erste Recheneinheit (8a) dazu ausgestaltet ist eine Meldung (23) über die zumindest eine Aussage über den Zustand der Sensoreinheit (3) zu generieren und auszugeben

7. Verfahren zum Betreiben einer Vorrichtung (1) zur Bestimmung und/oder Überwachung eines vorgegebenen Füllstands eines Mediums (2) in einem Behälter (2a),
wobei es sich bei der Vorrichtung (1) um ein Zweileiter-Messgerät handelt,
- wobei eine Sensoreinheit (3) mittels eines Anregesignals beaufschlagt wird, und ein Empfangssignal von der Sensoreinheit (3) empfangen wird,
- wobei in einem Normalbetriebsmodus (14) ein Erreichen des vorgegebenen Füllstands aus dem Empfangssignal bestimmt und in Form eines Ausgabe-Stromsignals über eine nach dem NAMUR-Standard ausgelegte Schnittstelle ausgegeben wird,
- wobei in einem Diagnosebetriebsmodus (15) zumindest eine Aussage über den Zustand der Sensoreinheit (3) getroffen wird,
- wobei die zumindest eine Aussage über den Zustand der Sensoreinheit (3) gespeichert wird,
- wobei zwischen dem Normalbetriebsmodus (14) und dem Diagnosebetriebsmodus (15) hin und her geschaltet wird, und
- wobei im Normalbetriebsmodus (14) die erste Recheneinheit (8a) betrieben wird, während die zweite Recheneinheit (8b) ausgeschaltet ist, und wobei im Diagnosebetriebsmodus (15) die zweite Recheneinheit (8b) betrieben wird, während die erste Recheneinheit (8a) ausgeschaltet ist.

8. Verfahren nach Anspruch 7 ,
wobei der Diagnosebetriebsmodus (15) durch Betätigung des zumindest einen Schaltelements (10a, 10b) gestartet wird.

9. Verfahren nach Anspruch 7 oder 8,
wobei bei jedem Neustart (17) des Feldgeräts (1) zuerst der Diagnosebetriebsmodus (15) ausgeführt wird.

10. Verfahren nach zumindest einem der Ansprüche 7-9,
wobei der Diagnosebetriebsmodus (15) durch Betätigen des zumindest einen Schaltelements (10a, 10b) beendet wird, und wobei gleichzeitig der Normalbetriebsmodus (14) gestartet wird.

11. Verfahren nach zumindest einem der Ansprüche 7-10,
wobei der Diagnosebetriebsmodus (15) durch die zweite Recheneinheit (8b) beendet wird, und wobei gleichzeitig der Normalbetriebsmodus (14) gestartet wird.

12. Verfahren nach zumindest einem der Ansprüche 7-11,
wobei im Falle eines Defekts oder einer Fehlfunktion der Sensoreinheit (3) eine Meldung (23) generiert und ausgegeben wird.

13. Verfahren nach zumindest einem der Ansprüche 7-12,
wobei die Meldung (23) von der ersten Recheneinheit (8a) ausgegeben wird.

## Claims

1. Apparatus (1) designed to determine and/or monitor a predefined level of a medium (2) in a vessel (2a) with a sensor unit (3) and an electronics unit (6),
wherein the apparatus (1) is a two-wire measuring device,
wherein the electronics unit (6) is designed to apply an excitation signal to the sensor unit (3) and to receive a reception signal from the sensor unit (3),
wherein the electronics unit (6) comprises at least
- an interface designed according to the NAMUR standard,
- a first calculation unit (8a), which is designed - in a normal operating mode (14) - to determine whether a predefined level is reached on the basis of the reception signal, and to output this information in the form of an output current signal via the interface,
- a second calculation unit (8b), which is designed - in a diagnostic operating mode - to provide a statement about the state of the sensor unit (3),
- at least one intermediate memory (9, 9a, 9b, ...), which is designed to save the at least one statement about the state of the sensor unit (3), and which is electrically connected to the first calculation unit (8a) and to the second calculation unit (8b), and
- at least a switch element (10a, 10b), which makes it possible to switch between the normal operating mode (14) and the diagnostic operating mode (15) and vice versa, wherein the switch element (10a, 10b) is arranged and designed in such a way that the first calculation unit (8a) is operated in the normal operating mode (14) while the second calculation unit (8b) is switched off, and in such a way that the second calculation unit (8b) is operated in the diagnostic operating mode (15) when the first calculation unit (8a) is switched off.

2. Apparatus (1) as claimed in Claim 1,
wherein at least two intermediate memories (9, 9a, 9b, ...) are provided, wherein said memories are electrically switched in parallel to one another, and
wherein a first statement about the state of the sensor unit (3) can be saved in the first intermediate memory (9) and
wherein a second statement about the state of the sensor unit (3) can be saved in the second intermediate memory (9a).

3. Apparatus as claimed in Claim 1 or 2,
wherein the intermediate memory (9, 9a, 9b, ...) is a multivibrator circuit.

4. Apparatus as claimed in at least one of the previous claims,
wherein the intermediate memory (9, 9a, 9b, ...) comprises at least a capacitor, a transistor circuit, a diode circuit and/or a memory module, particularly an NVRAM.

5. Apparatus as claimed in at least one of the previous claims,
wherein the switch element (10a, 10b) is an electrical toggle switch or at least two electrical switches.

6. Apparatus as claimed in at least one of the previous claims,
wherein the first calculation unit (8a) is designed to generate and output a message (23) about the at least one statement concerning the state of the sensor unit (3).

7. Procedure to operate an apparatus (1) to determine and/or monitor a predefined level of a medium (2) in a vessel (2a),
wherein the apparatus (1) is a two-wire measuring device,
- wherein an excitation signal is applied to a sensor unit (3), and a reception signal is received from the sensor unit (3),
- wherein the reaching of the predefined level is determined, in the normal operating mode (14), on the basis of the reception signal, and wherein said reception signal is output in the form of an output current signal via an interface designed according to the NAMUR standard,
- wherein at least one statement is made about the state of the sensor unit (3) in a diagnostic operating mode (15),
- wherein the at least one statement about the state of the sensor unit (3) is saved,
- wherein switching is performed between the normal operating mode (14) and the diagnostic operating mode (15) and vice versa, and
- wherein the first calculation unit (8a) is operated in the normal operating mode (14) while the second calculation unit (8b) is switched off, and
wherein the second calculation unit (8b) is operated in the diagnostic operating mode (15) while the first calculation unit (8a) is switched off.

8. Procedure as claimed in Claim 7,
wherein the diagnostic operating mode (15) is started by pressing the at least one switch element (10a, 10b).

9. Procedure as claimed in Claim 7 or 8,
wherein, at each restart (17) of the field device (1), the diagnostic operating mode (15) is executed first of all.

10. Procedure as claimed in at least one of the Claims 7 to 9,
wherein the diagnostic operating mode (15) is stopped by pressing the at least one switch element (10a, 10b) and
wherein the normal operating mode (14) is started simultaneously.

11. Procedure as claimed in at least one of the Claims 7 to 10,
wherein the diagnostic operating mode (15) is stopped by the second calculation unit (8b) and
wherein the normal operating mode (14) is started simultaneously.

12. Procedure as claimed in at least one of the Claims 7 to 11,
wherein, in the event of a defect or a malfunction of the sensor unit (3), a message (23) is generated and output.

13. Procedure as claimed in at least one of the Claims 7 to 12,
wherein the message (23) is output by the first calculation unit (8a).

## Revendications

1. Dispositif (1) destiné à la détermination et/ou à la surveillance d'un niveau prédéfini d'un produit (2) dans un réservoir (2a) avec une unité de capteur (3) et une unité électronique (6),
dispositif (1) pour lequel il s'agit d'un appareil de mesure 2 fils,
pour lequel l'unité électronique (6) est conçue pour alimenter l'unité de capteur (3) avec un signal d'excitation et à recevoir un signal de réception en provenance de l'unité de capteur (3),
pour lequel l'unité électronique (6) comprend au moins
- une interface conçue selon la norme NAMUR,
- une première unité de calcul (8a), laquelle est conçue, dans un mode de fonctionnement normal (14), pour déterminer à partir du signal de réception une atteinte du niveau prédéfini, et pour émettre ce niveau sous la forme d'un signal de courant de sortie via l'interface,
- une deuxième unité de calcul (8b), laquelle est conçue, dans un mode de diagnostic, pour donner une indication sur l'état de l'unité de capteur (3),
- au moins une mémoire intermédiaire (9, 9a, 9b, ...), laquelle est conçue pour mémoriser l'au moins une indication sur l'état de l'unité de capteur (3), et laquelle est reliée électriquement avec la première unité de calcul (8a) et avec la deuxième unité de calcul (8b), et
- au moins un élément de commutation (10a, 10b), lequel permet de commuter entre le mode de fonctionnement normal (14) et le mode de diagnostic (15) et vice versa, l'élément de commutation (10a, 10b) étant disposé et conçu de telle sorte que la première unité de calcul (8a) est exploitée en mode de fonctionnement normal (14) pendant que la deuxième unité de calcul (8b) est désactivée, et de telle sorte que la deuxième unité de calcul (8b) est exploitée en mode de diagnostic (15) pendant que la première unité de calcul (8a) est désactivée.

2. Dispositif (1) selon la revendication 1,
pour lequel sont prévues au moins deux mémoires intermédiaires (9, 9a, 9b, ...), lesquelles sont commutées électriquement en parallèle l'une par rapport à l'autre, et dispositif pour lequel une première indication sur l'état de l'unité de capteur (3) peut être mémorisée dans la première mémoire intermédiaire (9) et
dispositif pour lequel une deuxième indication sur l'état de l'unité de capteur (3) peut être mémorisée dans la deuxième mémoire intermédiaire (9a).

3. Dispositif selon la revendication 1 ou 2,
pour lequel il s'agit, concernant la mémoire intermédiaire (9, 9a, 9b, ...), d'une bascule monostable.

4. Dispositif selon au moins l'une des revendications précédentes,
pour lequel la mémoire intermédiaire (9, 9a, 9b, ...) comprend au moins un condensateur, un circuit à transistor, un circuit à diode et/ou un module mémoire, notamment une NVRAM.

5. Dispositif selon au moins l'une des revendications précédentes,
pour lequel il s'agit, concernant l'élément de commutation (10a, 10b), d'un commutateur électrique ou au moins de deux interrupteurs électriques.

6. Dispositif selon au moins l'une des revendications précédentes,
pour lequel la première unité de calcul (8a) est conçue pour générer et émettre un message (23) sur au minimum l'au moins une indication concernant l'état de l'unité de capteur (3).

7. Procédé pour l'exploitation d'un dispositif (1) destiné à la détermination et/ou à la surveillance d'un niveau prédéfini d'un produit (2) dans un réservoir (2a),
dispositif (1) pour lequel il s'agit d'un appareil de mesure 2 fils,
- une unité de capteur (3) étant alimentée par un signal d'excitation, et un signal de réception étant reçu par l'unité de capteur (3),
- une atteinte du niveau prédéfini étant déterminée, dans un mode de fonctionnement normal (14), à partir du signal de réception, et lequel signal de réception étant émis sous la forme d'un signal de courant de sortie via une interface conçue selon la norme NAMUR,
- au moins une indication sur l'état de l'unité de capteur (3) étant donnée dans un mode de diagnostic (15),
- l'au moins une indication sur l'état de l'unité de capteur (3) étant mémorisée,
- une commutation s'effectuant entre le mode de fonctionnement normal (14) et le mode de diagnostic (15) et vice versa, et
- la première unité de calcul (8a) étant exploitée dans le mode de fonctionnement normal (14) pendant que la deuxième unité de calcul (8b) est désactivée, et
la deuxième unité de calcul (8b) étant exploitée dans le mode de diagnostic (15) pendant que la première unité de calcul (8a) est désactivée.

8. Procédé selon la revendication 7,
pour lequel le mode de diagnostic (15) est démarré par l'actionnement de l'au moins un élément de commutation (10a, 10b).

9. Procédé selon la revendication 7 ou 8,
pour lequel, à chaque redémarrage (17) de l'appareil de terrain (1), le mode de diagnostic (15) est tout d'abord exécuté.

10. Procédé selon au moins l'une des revendications 7 à 9,
pour lequel le mode de diagnostic (15) est terminé par l'actionnement de l'au moins un élément de commutation (10a, 10b) et
pour lequel le mode de fonctionnement normal (14) est démarré simultanément.

11. Procédé selon au moins l'une des revendications 7 à 10,
pour lequel le mode de diagnostic (15) est terminé par la deuxième unité de calcul (8b) et pour lequel le mode de fonctionnement normal (14) est démarré simultanément.

12. Procédé selon au moins l'une des revendications 7 à 11,
pour lequel, en cas de défaut ou de dysfonctionnement de l'unité de capteur (3), un message (23) est généré et émis.

13. Procédé selon au moins l'une des revendications 7 à 12,
pour lequel le message (23) est émis par la première unité de calcul (8a).
